# EUROPEAN PATENT SPECIFICATION

(11) **EP 2 028 664 B1**
(45) Date of publication and mention of the grant of the patent: **30.12.2015**
(21) Application number: 07745061.7
(22) Date of filing: 12.06.2007
(51) Int. Cl.: H01F 17/00, H01G 4/12, H05K 3/46

(54) **LAMINATED CERAMIC ELECTRONIC COMPONENT**
LAMINIERTE KERAMISCHE ELEKTRONISCHE KOMPONENTE
COMPOSANT ÉLECTRONIQUE EN CÉRAMIQUE STRATIFIÉE

(30) Priority: 14.06.2006 JP 2006164195
(43) Date of publication of application: 25.02.2009
(73) Proprietor: Murata Manufacturing Co. Ltd., Nagaokakyo-shi, Kyoto 617-8555 (JP)
(72) Inventor: NISHIZAWA, Yoshihiko, Nagaokakyo-shi, Kyoto 617-8555 (JP)
(74) Representative: Zimmermann, Tankred Klaus
(86) International application number: PCT/JP2007/061774
(87) International publication number: WO 2007/145189

(56) References cited:
- JP-A- 06 077 022
- JP-A- 07 201 566
- JP-A- 2002 118 033
- JP-A- 2005 183 890
- US-A- 5 476 728
- US-B1- 6 515 568

## Description

### Technical Field

The present invention relates to multilayer ceramic electronic components, and, in particular, to improvement in the mechanical strength of a multilayer ceramic electronic component including a ceramic laminate composed of ceramic materials, such as ferrite materials, substantially entirely formed of a polycrystalline phase.

### Background Art

Multilayer ceramic electronic components of interest in the present invention are multilayer ceramic electronic components having composite multilayer structures composed of magnetic materials (ferrite materials) and formed by co-firing and are described in, for example, Japanese Unexamined Patent Application Publication Nos. 7-201566 (Patent Document 1) and 2005-183890 (Patent Document 2).

More specifically, Patent Document 1 describes a multilayer ceramic electronic component in which low-permeability magnetic layers are stacked on upper and lower surfaces of a high-permeability magnetic layer having a coil therein to prevent electrical interference between the coil and the surface conductive patterns.

Patent Document 2 describes a multilayer ceramic electronic component in which insulating layers are stacked on upper and lower surfaces of a magnetic layer having a coil therein to increase the degree of flexibility in the arrangement of surface-mounted circuit parts.

In the multilayer ceramic electronic component described in Patent Document 1, however, it is difficult to obtain sufficient mechanical strength because the ferrite material is fundamentally brittle.

In the multilayer ceramic electronic component described in Patent Document 2, sufficient mechanical strength can be obtained, depending on the type of an insulating material constituting the insulating layers. However, delamination, cracking, and warpage occur because of the difference in shrinkage behavior between the magnetic layer and the insulating layers, in some cases.
Patent Document 1: Japanese Unexamined Patent Application Publication No. 7-201566
Patent Document 2: Japanese Unexamined Patent Application Publication No. 2005-183890

US 6515568 B1 discloses a laminate including a plurality of first magnetic substances having a high magnetic permeability, and a plurality of second magnetic substances having a low magnetic permeability or non-magnetic substances. The second magnetic substances are located so that the inductance element in each of the first magnetic substances causes magnetic saturation in response to direct currents of substantially the same magnitude flowing therein.

US 5476728 A discloses a non-magnetic ferrite composition used in a composite multilayer part. The composition is based on ferrite containing Fe₂O₃ and CuO and/or ZnO and further contains 1 to 30% by weight of four oxide components of MgO, BaO, SiO₂, and B₂O₃ or five or six oxide components including the four oxide components plus at least one of SnO₂ and CaO. Since the use of this non-magnetic ferrite minimizes the difference in coefficient of linear expansion between different materials used, the non-magnetic ferrite, when applied to composite multilayer parts such as shielded multilayer chip inductors, shielded multilayer transformers, and multilayer LC composite parts, prevents occurrence of cracks in the interior and avoids a lowering of circuit resistance due to precipitation of CuO, ZnO or the like at the interface between different materials.

### Disclosure of Invention

### Problems to be Solved by the Invention

Accordingly, it is an object of the present invention to provide a multilayer ceramic electronic component that can overcome the forgoing problems.

### Means for Solving the Problems

The present invention is directed to a multilayer ceramic electronic component including a ceramic laminate with a multilayer structure having a ceramic base layer composed substantially entirely of a polycrystalline phase and one or more ceramic auxiliary layers, the ceramic base layer and the one or more ceramic auxiliary layers being formed by co-firing, the one or more ceramic auxiliary layers being arranged on at least one main surface of the ceramic base layer and composed substantially entirely of a polycrystalline phase, and one or more conductive patterns arranged inside and/or outside the ceramic laminate. To overcome the foregoing technical problems, the multilayer ceramic electronic component has the following structure.

The polycrystalline phase in the ceramic base layer and the polycrystalline phase in the one or more ceramic auxiliary layers have substantially the same crystal structure, and the one or more ceramic auxiliary layers have a linear expansion coefficient α2 lower than the linear expansion coefficient α1 of the ceramic base layer.

The present invention is particularly advantageously applied when the polycrystalline phase in the ceramic base layer and the polycrystalline phase of the one or more ceramic auxiliary layers are composed of ferrite materials.

In the embodiment described above, the ferrite material constituting the ceramic base layer and the ferrite material constituting the one or more ceramic auxiliary layers preferably have the same compositional system. Preferably, the ferrite material constituting the one or more ceramic auxiliary layers has a low permeability or is nonmagnetic. Preferably, the ferrite material is a spinel ferrite material (MFe₂O₄, wherein M represents a divalent metal ion) or a garnet ferrite material (R₃Fe₅O₁₂, wherein R represents trivalent metal ion).

In the multilayer ceramic electronic component according to the present invention, preferably, the one or more conductive patterns include a coil pattern portion arranged in the ceramic base layer.

Preferably, the one or more conductive patterns are mainly composed of silver.

Preferably, the one or more ceramic auxiliary layers are further arranged in the ceramic base layer.

Preferably, the one or more ceramic auxiliary layers are substantially symmetrically arranged in the thickness direction of the ceramic laminate with respect to the center of the ceramic laminate in the thickness direction.

Preferably, the difference, α1 - α2, between the linear expansion coefficient α1 of the ceramic base layer and the linear expansion coefficient α2 of the one or more ceramic auxiliary layers is in the range of 0.2 to 5 ppm/°C. Advantages

After an unsintered ceramic material is sintered by firing, the sintered ceramic material shrinks in proportion to the linear expansion coefficient thereof during cooling. According to the present invention, the ceramic auxiliary layer having a linear expansion coefficient lower than the linear expansion coefficient of the ceramic base layer is arranged on at least one main surface of the ceramic base layer; hence, the ceramic base layer tried to shrink more than the ceramic auxiliary layer. As a result, a compressive stress remains in the main surface of the multilayer ceramic electronic component on which the ceramic auxiliary layer is mounted after the completion of the cooling. Therefore, the multilayer ceramic electronic component has improved mechanical strength.

According to the present invention, the polycrystalline phase in the ceramic base layer and the polycrystalline phase of the ceramic auxiliary layer have substantially the same crystal structure. Thus, the ceramic base layer and the ceramic auxiliary layer are sintered and strongly bonded, thereby significantly preventing the occurrence of defects such as delamination and cracking in the interfaces.

According to the present invention, the ceramic base layer and the ceramic auxiliary layer are formed substantially entirely of the polycrystalline phases and substantially free from glass (amorphous phase). This results in the elimination of a problem, e.g., an undesired change in properties of the ceramic materials due to the interdiffusion of glass.

In the case where the polycrystalline phase in the ceramic base layer and the polycrystalline phase in the ceramic auxiliary layer are both composed of ferrite materials, the effect of improving the mechanical strength according to the present invention is further significant because the ferrite materials have fundamentally low mechanical strength.

In the foregoing case, when the ferrite material constituting the ceramic base layer and the ferrite material constituting the ceramic auxiliary layer have the same compositional system, a change in properties due to the interdiffusion of the components can be suppressed to a low level during the co-firing of the ceramic base layer and the ceramic auxiliary layer.

When the ferrite material constituting the ceramic auxiliary layer has a low permeability or is nonmagnetic, the generation of an undesired magnetic field induced by the conductive patterns arranged on and/or in the surface of the ceramic auxiliary layer can be suppressed, thereby reducing an undesired effect on an IC chip mounted on the surface of the multilayer ceramic electronic component and the coil pattern embedded in the ceramic base layer.

When the coil pattern as a conductive pattern is formed in the ceramic base layer, the coil pattern can provide a large inductance value.

In the multilayer ceramic electronic component according to the present invention, when the conductive pattern is mainly composed of silver, a firing step of forming a multilayer ceramic electronic component may be performed in an oxidizing atmosphere such as air.

In the case where a ceramic auxiliary layer is also arranged in the ceramic base layer, in particular, a multilayer ceramic electronic component having a large thickness dimension can have further improved mechanical strength. That is, a large thickness dimension is liable to cause internal stress due to the difference in linear expansion coefficient in a portion of the ceramic base layer remote from thee ceramic auxiliary layer arranged on the main surface of the ceramic base layer, possibly causing a reduction in strength. In contrast, the arrangement of the ceramic auxiliary layer having a relatively low linear expansion coefficient in the ceramic base layer can relieve the internal stress, thereby improving the mechanical strength of the multilayer ceramic electronic component. Furthermore, in the case where the coil pattern is arranged in the ceramic base layer and where a nonmagnetic ceramic auxiliary layer is arranged in the ceramic base layer, a coil constituted by the coil pattern forms an open magnetic circuit, thus improving the properties when a dc current is superimposed. Therefore, the coil can also be used at higher current.

In the case where the ceramic auxiliary layers are substantially symmetrically arranged in the thickness direction of the ceramic laminate with respect to the center of the ceramic laminate in the thickness direction, this arrangement can reliably relieve the internal stress causing a decrease in the strength of the multilayer ceramic electronic component and prevent warpage possibly occurring in the firing step.

In the case where the difference, α1 - α2, between the linear expansion coefficient α1 of the ceramic base layer and the linear expansion coefficient α2 of the ceramic auxiliary layer is set in the range of 0.2 to 5 ppm/°C, cracks and the like do not form, so that the effect of improving the strength can be assuredly provided. Brief Description of Drawings
[Fig. 1] Fig. 1 is a cross-sectional view of a multilayer ceramic electronic component 1 according to a first embodiment of the present invention.
[Fig. 2] Fig. 2 is a cross-sectional view of a multilayer ceramic electronic component 1a according to a second embodiment of the present invention.
[Fig. 3] Fig. 3 is a cross-sectional view of a multilayer ceramic electronic component 1b according to a third embodiment of the present invention.
[Fig. 4] Fig. 4 is a cross-sectional view of a multilayer ceramic electronic component 1c according to a third embodiment of the present invention.

### Reference Numerals

- 1, 1a, 1b, 1c: multilayer ceramic electronic component
- 2: ceramic base layer
- 3, 4, 13: ceramic auxiliary layer
- 5: ceramic laminate
- 6: in-plane conductor
- 7: interlayer connection conductor
- 8: coil pattern

### Best Modes for Carrying Out the Invention

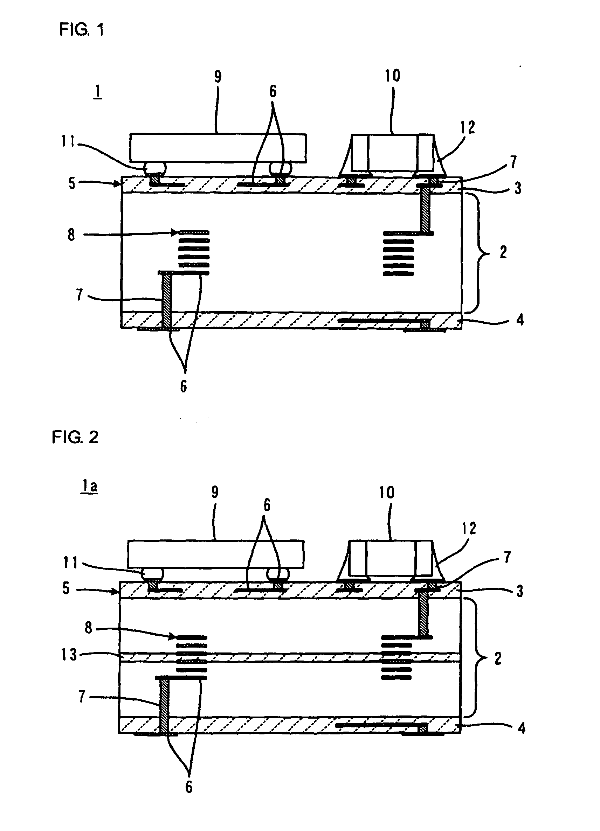

Fig. 1 is a cross-sectional view of a multilayer ceramic electronic component 1 according to a first embodiment of the present invention.

The multilayer ceramic electronic component 1 includes a ceramic laminate 5 with a multilayer structure having a ceramic base layer 2 and ceramic auxiliary layers 3 and 4, the ceramic base layer 2 and the ceramic auxiliary layers 3 and 4 being formed by co-firing, and the ceramic auxiliary layers 3 and 4 being arranged on the respective upper and lower main surfaces of the ceramic base layer 2.

The multilayer ceramic electronic component 1 also includes conductive patterns arranged inside and/or outside the ceramic laminate 5. The conductive patterns are broadly divided into in-plane conductors 6 and interlayer connection conductors 7. The in-plane conductors 6 are arranged on main surfaces of ceramic green sheets stacked for forming the ceramic base layer 2 or the ceramic auxiliary layer 3 or 4. The interlayer connection conductors 7 are arranged through the ceramic green sheets in the thickness direction. Combinations of specific in-plane conductors 6 and specific interlayer connection conductors 7 form coil patterns 8 in the ceramic base layer 2. The interlayer connection conductors 7 partially constituting the coil patterns 8 are not shown in Fig. 1.

The multilayer ceramic electronic component 1 constitutes, for example, a DC-DC converter and includes surface-mounted components 9 and 10 mounted on the upper main surface of the ceramic laminate 5. The surface-mounted component 9 is, for example, an IC chip electrically connected to the in-plane conductors 6 arranged on the upper main surface of the ceramic laminate 5 through solder bumps 11. The other surface-mounted component 10 is, for example, a chip capacitor electrically connected to the in-plane conductors 6 arranged on the upper main surface of the ceramic laminate 5 with solder 12. The in-plane conductors 6 arranged on the lower main surface of the ceramic laminate 5 serve as terminal electrodes used when the multilayer ceramic electronic component 1 is mounted on a motherboard, not shown.

The ceramic base layer 2 and the ceramic auxiliary layers 3 and 4 are composed of materials each substantially entirely formed of a polycrystalline phase. The polycrystalline phase in the ceramic base layer 2 and the polycrystalline phase in the ceramic auxiliary layers 3 and 4 have substantially the same crystal structure. In addition, the ceramic auxiliary layers 3 and 4 have a linear expansion coefficient α2 lower than the linear expansion coefficient α1 of the ceramic base layer 2.

In a preferred embodiment, the polycrystalline phase in the ceramic base layer 2 and the polycrystalline phase in the ceramic auxiliary layers 3 and 4 are composed of polycrystalline phases composed of ferrite materials. In this case, the ceramic base layer 2 and the ceramic auxiliary layers 3 and 4 are preferably composed of ferrite materials having the same compositional system. The phrase "ferrite materials having the same compositional system" defined here indicates ferrite materials having common constituent elements and different proportions of the constituent elements.

Since the ceramic base layer 2 and the ceramic auxiliary layers 3 and 4 are composed of the ferrite materials having the same compositional system, a change in properties due to interdiffusion of the components can be minimized during co-firing to form the ceramic base layer 2 and the ceramic auxiliary layers 3 and 4.

The ferrite material constituting the ceramic auxiliary layers 3 and 4 preferably is a low-permeability (for example, 30 or less) ferrite material or a nonmagnetic (having a permeability of 1) ferrite material. If the ceramic auxiliary layers 3 and 4 are composed of a high-permeability ferrite material, the flow of a current through a conductive pattern arranged thereon may generate an undesired magnetic field to adversely affect electrical properties of the IC chip serving as the surface-mounted component 9 and the coil patterns 8 in the ceramic base layer 2. In contrast, the ceramic auxiliary layers 3 and 4 composed of a low-permeability or nonmagnetic ferrite material can suppress the generation of an undesired magnetic field induced by the conductive patterns arranged on and/or in the ceramic auxiliary layers 3 and 4.

The ceramic base layer 2 and the ceramic auxiliary layers 3 and 4 may be composed of, for example, Fe-Ni-Zn-Cu-based ferrite materials.

In this case, when a mixture containing ferric oxide (Fe₂O₃), zinc oxide (ZnO), nickel oxide (NiO), and copper oxide (CuO) in predetermined proportions is used as a material to be formed into the ferrite material constituting the ceramic base layer 2, a sintered body of the material can have a permeability of 150 at 1 MHz and a linear expansion coefficient α1 of 10.5.

When a mixture containing ferric oxide, zinc oxide, nickel oxide, and copper oxide in proportions different from the above is used as a material to be formed into the ferrite material constituting the ceramic auxiliary layers 3 and 4, a sintered body of the material can have a permeability of 20 at 1 MHz and a linear expansion coefficient α2 of 9.5.

Alternatively, when the ceramic auxiliary layers 3 and 4 are composed of a nonmagnetic ferrite material, for example, an Fe-Zn-Cu-based ferrite material may be used. For example, when a mixture containing ferric oxide, zinc oxide, and copper oxide in predetermined proportions is used, a sintered body of the mixture can have a permeability of 1.0 at 1 MHz and a linear expansion coefficient α2 of 9.0.

In the foregoing embodiments, the Fe-Ni-Zn-Cu-based or Fe-Zn-Cu-based ferrite material is used. Alternatively, an Fe-Mn-Zn-based ferrite material may be used. These ferrite materials all have a spinel structure. Alternatively, a ferrite material having another crystal structure, such as a garnet structure, may be used.

Examples of the spinel ferrite material (MFe₂O₄, wherein M represents a divalent metal ion) include nickel zinc ferrite (Ni₁₋ₓZnₓ)Fe₂O₄, manganese zinc ferrite (Mn_{1-X}Zn_{X})Fe₂O₄, nickel ferrite NiFe₂O₄, manganese ferrite MnFe₂O₄, zinc ferrite ZnFe₂O₄, copper ferrite CuFe₂O₄, cobalt ferrite CoFe₂O₄, magnesium ferrite MgFe₂O₄, lithium ferrite (Li_{0.5}Fe_{0.5})Fe₂O₄, γ-iron oxide (γ-Fe₂O₃), Fe_{2/3}□_{1/3}Fe₂O₄ (wherein □ represents a vacancy), and magnetite (ferrous ferrite) Fe₃O₄.

Examples of the garnet ferrite material (R₃Fe₅O₁₂, wherein R represents a trivalent metal ion) include yttrium iron garnet (YIG) Y₃Fe₅O₁₂ (CVG) Ca₃Fe_{3.5}V_{1.5}O₁₂, and gadolinium iron garnet Gd₃Fe₅O₁₂.

A method for producing the multilayer ceramic electronic component 1 will be described below.

Ceramic green sheets to be formed into the ceramic base layer 2 and the ceramic auxiliary layers 3 and 4 are prepared. These ceramic green sheets are provided by adding a binder, a plasticizer, a wetting agent, a dispersant, and the like to the ferrite raw material powders described above to form a slurry and forming the slurry into sheets.

Through holes are formed in specific ceramic green sheets. The through holes are filled with a conductive paste to form unsintered interlayer connection conductors 7. The conductive paste is applied onto specific ceramic green sheets by printing to form unsintered in-plane conductors 6. The conductive paste for forming the in-plane conductors 6 and the interlayer connection conductors 7 preferably contains a conductive metal mainly composed of silver because such a conductive paste can be fired in an oxidizing atmosphere such as air in a firing step described below and provide satisfactory conductivity.

Preferably, the conductive patterns except the conductive patterns to be formed into the in-plane conductors 6 and the interlayer connection conductors 7 configured to form the coil patterns 8 are formed on the ceramic green sheets to be formed into the ceramic auxiliary layers 3 and 4 to the maximum extent possible.

To form the ceramic base layer 2 and the ceramic auxiliary layers 3 and 4, predetermined numbers of ceramic green sheets are stacked in a predetermined order and press-bonded to form an unsintered ceramic laminate 5. In the case where the foregoing steps are performed to form a source ceramic laminate configured to simultaneously produce a plurality of multilayer ceramic electronic components 1, grooves for facilitating the separation of the source ceramic laminate are formed.

The unsintered ceramic laminate is fired in an oxidizing atmosphere such as air to form the sintered ceramic laminate 5.

The in-plane conductors 6 exposed at surfaces of the ceramic laminate 5 are subjected to plating treatment. For example, electroless plating is performed to form nickel plating films and then gold plating films.

The surface-mounted component 9 and 10 are mounted on the upper main surface of the ceramic laminate 5.

In the case where the foregoing steps are performed to the source ceramic laminate, the step of separating the source ceramic laminate along the grooves into individual multilayer ceramic electronic components 1. A metal cover, not shown, is attached to each of the multilayer ceramic electronic components 1, as needed.

In the foregoing description, the grooves are formed before the firing step. Alternatively, the source ceramic laminate may be separated into individual unsintered ceramic laminates 5 for the multilayer ceramic electronic components 1 before the firing step without forming grooves. In this case, the firing step is performed for the individual ceramic laminates 5. For the plating treatment, electroplating, such as barrel plating, is performed.

In the resulting multilayer ceramic electronic component 1 as described above, the ceramic laminate 5 shrinks in a cooling step subsequent to the firing step. The degree of shrinkage is proportional to the linear expansion coefficient of the ceramic material. In this embodiment, the linear expansion coefficient α2 of the ceramic auxiliary layers 3 and 4 is lower than the linear expansion coefficient α1 of the ceramic base layer 2; hence, the ceramic base layer 2 tries to shrink more. As a result, compressive stresses remain in both main surfaces of the ceramic laminate 5 after the completion of cooling. Therefore, the ceramic laminate 5 and thus the multilayer ceramic electronic component 1 have high mechanical strength.

The difference in linear expansion coefficient between the ceramic auxiliary layers 3 and 4 and the ceramic base layer 2 is generally liable to cause delamination and cracks. In this embodiment, however, the ceramic auxiliary layers 3 and 4 and the ceramic base layer 2 are composed of the ceramic materials having substantially the same crystal structure; hence, the ceramic auxiliary layers 3 and 4 and the ceramic base layer 2 are strongly bonded to each other by sintering the ceramic materials, thereby not easily causing defects such as delamination and cracks described above.

The ceramic auxiliary layers 3 and 4 and the ceramic base layer 2 are formed substantially entirely of the polycrystalline phases and substantially free from a diffusive component such as glass (amorphous phase). Thus, an undesired change in composition due to diffusion does not occur easily, thereby providing the ceramic laminate 5 with high reliability.

The difference α1 - α2 between the linear expansion coefficient α1 of the ceramic base layer 2 and the linear expansion coefficient α2 of the ceramic auxiliary layers 3 and 4 is preferably in the range of 0.2 to 5 ppm/°C. This holds true for the above-described specific examples of the ferrite materials constituting the ceramic base layer 2 and the ceramic auxiliary layers 3 and 4. A difference of less than 0.2 ppm/°C results in a low effect of improving the strength. A difference exceeding 5 ppm/°C is liable to cause defects such as the formation of cracks in the ceramic laminate 5. The difference α1 - α2 of the linear expansion coefficients is more preferably in the range of 0.4 to 3 ppm/°C. In this case, the multilayer ceramic electronic component 1 having improved strength can be more stably produced.

Each of the ceramic auxiliary layers 3 and 4 preferably has a thickness of 5 to 300 µm. When each of the ceramic auxiliary layers 3 and 4 has a thickness of less than 5 µm, cracks form easily in the ceramic auxiliary layers 3 and 4 during cooling subsequent to firing. At a thickness exceeding 300 µm, compressive stresses due to the difference in linear expansion coefficient therebetween do not easily affect the surfaces of the ceramic laminate 5, thus not sufficiently providing the effect of improving the strength.

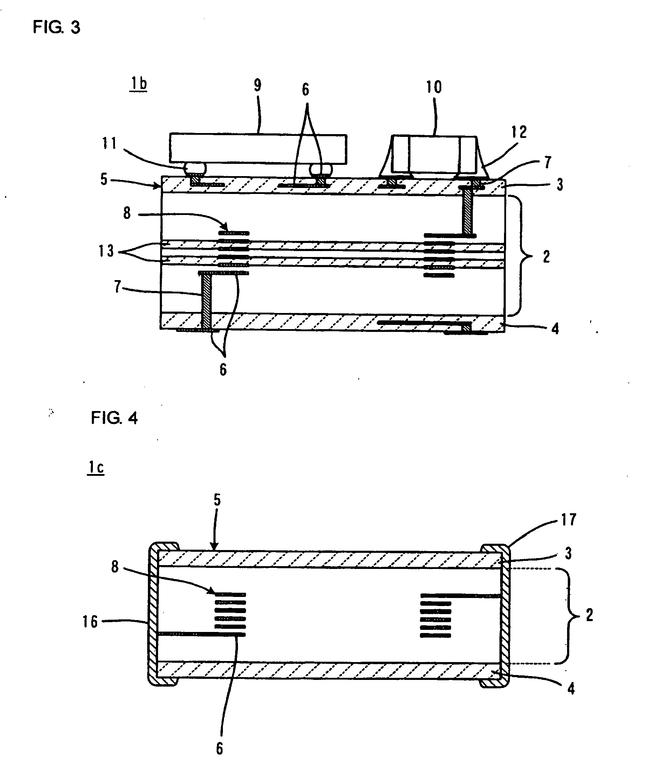

Figs. 2 and 3 show multilayer ceramic electronic components 1a and 1b according to second and third embodiments, respectively, of the present invention and each correspond to Fig. 1. In Figs. 2 and 3, elements equivalent to those shown in Fig. 1 are designated the same reference numerals, and descriptions are not redundantly repeated.

The multilayer ceramic electronic component 1a shown in Fig. 2 includes a ceramic auxiliary layer 13 arranged in the ceramic base layer 2 as well as the ceramic auxiliary layers 3 and 4 arranged on the main surfaces of the ceramic base layer 2. The multilayer ceramic electronic component 1b shown in Fig. 3 includes a plurality of the ceramic auxiliary layers 13, for example, two ceramic auxiliary layers 13.

The ceramic auxiliary layer 13 has the following effect.

In the case where the ceramic base layer 2 has a large thickness dimension, in particular, a thickness dimension of 500 µm or more, defects such as cracks may form in the ceramic base layer 2. In the ceramic base layer 2 having a relatively high linear expansion coefficient and the main surfaces fixed by the ceramic auxiliary layers 3 and 4 having a relatively low linear expansion coefficient, a shrinkage force is generated in the inside of the ceramic base layer 2. In the case where the ceramic base layer 2 has a thickness of, for example, less than 500 µm, the internal stress is not sufficient to reduce the strength of the ceramic base layer 2. However, the middle portion of the ceramic base layer 2 in the thickness direction tends to shrink as the ceramic base layer 2 has a larger thickness. The internal tensile stress is applied in the planar direction between the surface portions and the middle portion of the ceramic base layer 2, thereby easily causing cracks in side faces at or near the intermediate portions between the surface portions and the middle portion.

In view of the circumstances, the arrangement of the ceramic auxiliary layer 13 having a relatively low linear expansion coefficient in the ceramic base layer 2 can relieve an excessive internal shrinkage stress in the ceramic base layer 2. Thereby, the arrangement of the ceramic auxiliary layer 13 therein can provide sufficient mechanical strength even when the ceramic laminate 5 has a large thickness dimension, in particular, even when the ceramic base layer 2 has a larger thickness dimension.

In the case where the ceramic auxiliary layer 13 is arranged in the ceramic base layer 2 in such a manner that the continuous thickness of the ceramic base layer 2 is 300 µm or less and preferably 200 µm or less, the foregoing effect of improving the strength can be assuredly provided, and the ceramic laminate 5 can be produced more stably. Furthermore, the arrangement of the ceramic auxiliary layer 13 further improves the mechanical strength even when the ceramic base layer 2 has a thickness of 500 µm or less.

The ceramic auxiliary layer 13 preferably has a thickness of 5 µm or more. This is because at a thickness of less than 5 µm, the internal stress generated in the ceramic base layer 2 is not sufficiently relieved in some cases.

The ceramic auxiliary layer 13 is composed of the same material as the ceramic auxiliary layers 3 and 4. For example, any combination of the ceramic auxiliary layers 3 and 4 and the ceramic auxiliary layer 13, for example, a combination of the ceramic auxiliary layers 3 and 4 composed of a low-permeability ferrite material and the ceramic auxiliary layer 13 composed of a nonmagnetic ferrite material, may be used. In this case, the selection of the materials having the optimum permeability and linear expansion coefficient provides the multilayer ceramic electronic components 1a and 1b having excellent electrical properties and mechanical strength.

Figs. 2 and 3 clearly show that the ceramic auxiliary layers 3 and 4 and the ceramic auxiliary layers 13 are substantially symmetrically arranged in the thickness direction of the ceramic laminate 5 with respect to the center of the ceramic laminate 5 in the thickness direction. This arrangement can reliably relieve the internal stress causing a decrease in the strength of the ceramic laminate 5 and prevent warpage in the firing step. With respect to the ceramic auxiliary layers 3 and 4, they are substantially symmetrically arranged in the thickness direction of the ceramic laminate 5 in the multilayer ceramic electronic component 1 shown in Fig. 1, thus providing the same effect described above.

As shown in Figs. 2 and 3, preferably, the ceramic auxiliary layers 13 in the ceramic base layer 2 extends to end faces of the ceramic laminate 5. This can effectively relieve the internal stress in the vicinity of the end faces of the ceramic base layer 2, the internal stress causing cracks that form easily starting at the end faces of the ceramic laminate 5.

As shown in Figs. 2 and 3, the ceramic auxiliary layers 13 are preferably arranged at a portion where the coil patterns 8 are arranged when the ceramic auxiliary layers 13 are composed of a nonmagnetic material. In this case, coils constituted by the coil patterns 8 form open magnetic circuits and thus are not easily magnetically saturated, thus improving the properties when a dc current is superimposed. Therefore, the multilayer ceramic electronic components 1a and 1b can also be used at higher current.

The embodiments shown in the figures illustrating the present invention have been described above. Various changes may be made within the scope of the invention.

For example, preferably, the ceramic auxiliary layers 3 and 4 and the ceramic auxiliary layer 13 are arranged over the multilayer ceramic electronic components 1, 1a, and 1b in the planar direction. Alternatively, the layers may not be arranged over the components as long as the foregoing effect can be obtained. For example, regions, such as a notch and a hole, which are not covered with the layers, may be arranged.

The multilayer ceramic electronic components 1, 1a, and 1b shown in the figures are multi-function composite components including the surface-mounted components 9 and 10 mounted on the ceramic laminates 5. Alternatively, the present invention can also be applied to, for example, a chip inductor as shown in Fig. 4.

Fig. 4 is a cross-sectional view of a multilayer ceramic electronic component 1c constituting a chip inductor according to a fourth embodiment of the present invention. In Fig. 4, elements equivalent to those shown in Fig. 1 are designated using the same reference numerals, and descriptions are not redundantly repeated.

In the multilayer ceramic electronic component 1c constituting a chip inductor shown in Fig. 4, terminal conductors 16 and 17 are arranged on both ends of the ceramic laminate 5. Each of end portions of the coil patterns 8 extends to a corresponding one of the end faces of the ceramic laminate 5 and is electrically connected to a corresponding one of the terminal conductors 16 and 17.

## Claims

1. A multilayer ceramic electronic component (1; 1a; 1b; 1c) comprising a ceramic laminate with a multilayer structure having a ceramic base layer (2) composed entirely of a polycrystalline phase and one or more ceramic auxiliary layers (3, 4;), the ceramic base layer (2) and the one or more ceramic auxiliary layers (3, 4) being formed by co-firing, the one or more ceramic auxiliary layers (3, 4) being arranged on at least one main surface of the ceramic base layer (2), being arranged at an upper and/or lower outer surface of the ceramic laminate (5) and composed entirely of a polycrystalline phase; and
one or more conductive patterns (6, 7, 8) arranged inside and/or outside the ceramic laminate,
wherein the polycrystalline phase in the ceramic base layer (2) and the polycrystalline phase in the one or more ceramic auxiliary layers (3, 4) have the same crystal structure, and
the one or more ceramic auxiliary layers (3, 4) have a linear expansion coefficient α2 lower than the linear expansion coefficient α1 of the ceramic base layer (2),
wherein the difference, α1 - α2, between the linear expansion coefficient α1 of the ceramic base layer (2) and the linear expansion coefficient α2 of the one or more ceramic auxiliary layers (3, 4) is in the range of 0.4 to 3 ppm/°C.

2. The multilayer ceramic electronic component according to Claim 1, wherein the polycrystalline phase in the ceramic base layer (2) and the polycrystalline phase of the one or more ceramic auxiliary layers (3, 4) are composed of ferrite materials.

3. The multilayer ceramic electronic component according to Claim 2, wherein the ferrite material constituting the ceramic base layer (2) and the ferrite material constituting the one or more ceramic auxiliary layers (3, 4) have the same compositional system.

4. The multilayer ceramic electronic component according to Claim 2, wherein the ferrite material constituting the one or more ceramic auxiliary layers (3, 4) has a low permeability or is nonmagnetic.

5. The multilayer ceramic electronic component according to Claim 2, wherein the ferrite material is a spinel ferrite material (MFe₂O₄, wherein M represents a divalent metal ion) or a garnet ferrite material (R₃Fe₅O₁₂, wherein R represents trivalent metal ion).

6. The multilayer ceramic electronic component according to Claim 2, wherein the one or more conductive patterns (6, 7, 8) include a coil pattern portion (8) arranged in the ceramic base layer (2).

7. The multilayer ceramic electronic component according to Claim 1, wherein the one or more conductive patterns (6, 7, 8) are mainly composed of silver.

8. The multilayer ceramic electronic component according to Claim 1, wherein the one or more ceramic auxiliary layers (13) comprise a ceramic auxiliary layer (13) arranged in the ceramic base layer (2).

9. The multilayer ceramic electronic component according to Claim 1, wherein the one or more ceramic auxiliary layers (3, 4; 13) are symmetrically arranged in the thickness direction of the ceramic laminate with respect to the center of the ceramic laminate in the thickness direction.

## Patentansprüche

1. Eine mehrschichtige elektronische Keramikkomponente (1; 1a; 1b; 1c), die ein Keramiklaminat mit einer Mehrschichtstruktur aufweist, die eine keramische Basisschicht (2), die gänzlich aus einer polykristallinen Phase gebildet ist, und eine oder mehrere keramische Hilfsschichten (3, 4) aufweist, wobei die keramische Basisschicht (2) und die eine oder die mehreren keramischen Hilfsschichten (3, 4) durch gemeinsames Brennen gebildet sind, wobei die eine oder die mehreren keramischen Hilfsschichten (3, 4) auf zumindest einer Hauptoberfläche der keramischen Basisschicht (2) angeordnet sind, an einer oberen und/oder unteren Außenoberfläche des Keramiklaminats (5) angeordnet sind und gänzlich aus einer polykristallinen Phase gebildet sind; und
eine oder mehrere Leiterstrukturen (6, 7, 8), die in dem und/oder außerhalb des Keramiklaminats angeordnet sind,
wobei die polykristalline Phase in der keramischen Basisschicht (2) und die polykristalline Phase in der einen oder den mehreren keramischen Hilfsschichten (3, 4) dieselbe Kristallstruktur aufweisen, und
die eine oder die mehreren keramischen Hilfsschichten (3, 4) einen linearen Ausdehnungskoeffizienten α2 aufweisen, der geringer ist als der lineare Ausdehnungskoeffizient α1 der keramischen Basisschicht (2),
wobei die Differenz, α1 - α2, zwischen dem linearen Ausdehnungskoeffizienten α1 der keramischen Basisschicht (2) und dem linearen Ausdehnungskoeffizienten α2 der einen oder der mehreren keramischen Hilfsschichten (3, 4) im Bereich von 0,4 bis 3 ppm/°C liegt.

2. Die mehrschichtige elektronische Keramikkomponente gemäß Anspruch 1, bei der die polykristalline Phase in der keramischen Basisschicht (2) und die polykristalline Phase der einen oder der mehreren keramischen Hilfsschichten (3, 4) aus Ferritmaterialien gebildet sind.

3. Die mehrschichtige elektronische Keramikkomponente gemäß Anspruch 2, bei der das Ferritmaterial, das die keramische Basisschicht (2) bildet, und das Ferritmaterial, das die eine oder die mehreren keramischen Hilfsschichten (3, 4) bildet, dasselbe Zusammensetzungssystem aufweisen.

4. Die mehrschichtige elektronische Keramikkomponente gemäß Anspruch 2, bei der das Ferritmaterial, das die eine oder die mehreren keramischen Hilfsschichten (3, 4) bildet, eine geringe Durchlässigkeit aufweist oder nichtmagnetisch ist.

5. Die mehrschichtige elektronische Keramikkomponente gemäß Anspruch 2, bei der das Ferritmaterial ein Spinell-Ferritmaterial (MFe₂O₄, wobei M ein zweiwertiges Metallion darstellt) oder ein Granat-Ferritmaterial (R₃Fe₅O₁₂, wobei R ein dreiwertiges Metallion darstellt) ist.

6. Die mehrschichtige elektronische Keramikkomponente gemäß Anspruch 2, bei der die eine oder die mehreren Leiterstrukturen (6, 7, 8) einen Spulenstrukturabschnitt (8) umfassen, der in der keramischen Basisschicht (2) angeordnet ist.

7. Die mehrschichtige elektronische Keramikkomponente gemäß Anspruch 1, bei der die eine oder die mehreren Leiterstrukturen (6, 7, 8) hauptsächlich aus Silber gebildet sind.

8. Die mehrschichtige elektronische Keramikkomponente gemäß Anspruch 1, bei der die eine oder die mehreren keramischen Hilfsschichten (13) eine in der keramischen Basisschicht (2) angeordnete keramische Hilfsschicht (13) umfassen.

9. Die mehrschichtige elektronische Keramikkomponente gemäß Anspruch 1, bei der die eine oder die mehreren keramischen Hilfsschichten (3, 4; 13) in der Dickenrichtung des Keramiklaminats bezüglich der Mitte des Keramiklaminats in der Dickenrichtung symmetrisch angeordnet sind.

## Revendications

1. Composant électronique en céramique à plusieurs couches (1 ; 1a ; 1b ; 1c) comprenant un stratifié en céramique avec une structure à plusieurs couches ayant une couche de base en céramique (2) entièrement composée d'une phase polycristalline et une ou plusieurs couches auxiliaires en céramique (3, 4), la couche de base en céramique (2) et les une ou plusieurs couches auxiliaires (3, 4) étant formées par cocuisson, les une ou plusieurs couches auxiliaires en céramique (3, 4) étant agencées sur au moins une surface principale de la couche de base en céramique (2) étant agencées au niveau d'une surface externe supérieure et/ou inférieure du stratifié en céramique (5) et entièrement composées d'une phase polycristalline ; et
une ou plusieurs impressions conductrices (6, 7, 8) agencées à l'intérieur et/ou à l'extérieur du stratifié en céramique,
dans lequel la phase polycristalline dans la couche de base en céramique (2) et la phase polycristalline dans les une ou plusieurs couches auxiliaires en céramique (3, 4) ont la même structure cristalline, et
les une ou plusieurs couches auxiliaires en céramique (3, 4) ont un coefficient de dilatation linéaire α2 inférieur au coefficient de dilatation linéaire α1 de la couche de base en céramique (2),
dans lequel la différence α1 -- α2 entre le coefficient de dilatation linéaire α1 de la couche de base en céramique (2) et le coefficient de dilatation linéaire α2 des une ou plusieurs couches auxiliaires en céramique (3, 4) est dans la plage de 0,4 à 3 ppm/°C.

2. Composant électronique en céramique à plusieurs couches selon la revendication 1, dans lequel la phase polycrystalline dans la couche de base en céramique (2) et la phase polycrystalline des une ou plusieurs couches auxiliaires en céramique (3, 4) sont composées de matériaux de ferrite.

3. Composant électronique en céramique à plusieurs couches selon la revendication 2, dans lequel le matériau de ferrite constituant la couche de base en céramique (2) et le matériau de ferrite constituant les une ou plusieurs couches auxiliaires en céramique (3, 4) ont le même système de composition.

4. Composant électronique en céramique à plusieurs couches selon la revendication 2, dans lequel le matériau de ferrite constituant les une ou plusieurs couches auxiliaires en céramique (3, 4) a une faible perméabilité ou n'est pas magnétique.

5. Composant électronique en céramique à plusieurs couches selon la revendication 2, dans lequel le matériau de ferrite est un matériau de ferrite de spinelle (MFe₂O₄, dans lequel M représente un ion métallique divalent) ou un matériau de ferrite de grenat (R₃Fe₅O₁₂), dans lequel R représente un ion métallique trivalent).

6. Composant électronique en céramique à plusieurs couches selon la revendication 2, dans lequel les une ou plusieurs impressions conductrices (6, 7, 8) comprennent une partie d'impression hélicoïdale (8) agencée dans la couche de base en céramique (2).

7. Composant électronique en céramique à plusieurs couches selon la revendication 1, dans lequel les une ou plusieurs impressions conductrices (6, 7, 8) sont principalement composées d'argent.

8. Composant électronique en céramique à plusieurs couches selon la revendication 1, dans lequel les une ou plusieurs couches auxiliaires en céramique (13) comprennent une couche auxiliaire en céramique (13) agencée dans la couche de base en céramique (2).

9. Composant électronique en céramique à plusieurs couches selon la revendication 1, dans lequel les une ou plusieurs couches auxiliaires en céramique (3, 4 ; 13) sont agencées de manière symétrique dans le sens de l'épaisseur du stratifié en céramique par rapport au centre du stratifié en céramique dans le sens de l'épaisseur.
